# EUROPEAN PATENT SPECIFICATION

(11) **EP 4 506 492 B1**
(45) Date of publication and mention of the grant of the patent: **26.08.2026**
(21) Application number: 24768886.4
(22) Date of filing: 09.05.2024
(51) Int. Cl.: C30B 23/00, C30B 23/02, C30B 29/36, C30B 35/00

(54) **DEVICE AND METHOD FOR GROWING HIGH-QUALITY SILICON CARBIDE CRYSTAL**
VORRICHTUNG UND VERFAHREN ZUR ZÜCHTUNG VON SILICIUMCARBIDKRISTALLEN HOHER QUALITÄT
DISPOSITIF ET PROCÉDÉ DE CROISSANCE DE CRISTAL DE CARBURE DE SILICIUM DE HAUTE QUALITÉ

(30) Priority: 14.06.2023 CN 202310705595
(43) Date of publication of application: 12.02.2025
(73) Proprietor: Tongwei Microelectronics Co., Ltd., Chengdu, Sichuan 610299 (CN)
(72) Inventor: LIN, Yuyi, Chengdu, Sichuan 610299 (CN); LIU, Xi, Chengdu, Sichuan 610299 (CN); FENG, Chunlin, Chengdu, Sichuan 610299 (CN); XU, Hongli, Chengdu, Sichuan 610299 (CN)
(74) Representative: IPrime Bonnekamp Sparing Patentanwaltsgesellschaft mbH
(86) International application number: PCT/CN2024/091967
(87) International publication number: WO 2024/255490

(56) References cited:
- CN-A- 108 103 569
- CN-A- 114 892 275
- CN-A- 115 537 925
- CN-A- 115 838 972
- CN-A- 116 716 655
- CN-U- 217 378 098
- JP-A- 2010 163 335
- KR-A- 20200 075 954
- US-A1- 2012 285 370
- US-A1- 2022 090 295
- US-B2- 10 801 126

## Description

### TECHNICAL FIELD

The present disclosure relates to the field of silicon carbide crystal growth, in particular to an apparatus and method for growing high-quality silicon carbide crystals and silicon carbide crystals by sublimation of silicon carbide powder.

### BACKGROUND

Silicon carbide, which is a representative of third-generation semiconductor materials, has excellent properties such as large band gap, high saturated electron mobility, high breakdown field intensity, high thermal conductivity, and the like, and has been widely used in fields of power electronics, radio frequency devices, optoelectronic devices, and the like.

A guide plate is usually arranged on a middle-upper portion of an existing crucible for growing silicon carbide crystals in order to increase the growth rate of the silicon carbide crystals on a seed crystal, and meanwhile limit a growth size and shape of the silicon carbide crystals, so as to guide gaseous-phase crystal growth components (main components are SiₘCₙ, namely carbon-silicon components) to flow to the seed crystal as many as possible. However, in order to prevent the interference between the guide plate and the seed crystal, a gap is usually reserved between a top of the guide plate and an edge of the seed crystal, such gap will lead to a certain pressure difference between a chamber above the guide plate and a chamber below the guide plate at the early growth stage of the silicon carbide crystals, and the gaseous-phase crystal growth components have a high flow rate and flow at such gap, resulting in that the growth quality of the silicon carbide crystals is affected due to a "concave interface" caused by too high growth rate of the silicon carbide crystals. JP 2010 163335 A considered to represent the closest prior art shows an apparatus for growing high-quality silicon carbide crystals, comprising a crucible, wherein a seed crystal is arranged on a top wall of the crucible, and further comprising an annular guide plate arranged in said crucible and separating the chamber into a first upper chamber and a second lower chamber, wherein the chambers are formed by the crucible walls together with the annular guide plate and the seed crystal to which the guide plate extends. The chambers are connected by a small gap between the guide plate and the seed crystal and through air holes in the guide plate. Moreover, also US 2012/285370 A shows an apparatus for growing high-quality silicon carbide crystals, comprising a crucible, wherein an annular guide plate separates the chambers formed by the guide plate and the crucible walls and wherein the chambers are connected by a small gap between the guide plate and the seed crystal.

### SUMMARY

The object of the present disclosure is to, for example, provide an apparatus and method for growing high-quality silicon carbide crystals and silicon carbide crystals, according to which, the flow rate of gaseous-phase crystal growth components at a gap between a top of a guide plate and an edge of a seed crystal can be effectively reduced, and the silicon carbide crystals can uniformly grow on each portion of the seed crystal, thereby improving the growth quality of the silicon carbide crystals. This object is achieved by an apparatus with the features of claim 1 and a method with the features of claim 8.

Embodiments of the present disclosure may be implemented as follows:
in a first aspect, the present disclosure provides an apparatus for growing high-quality silicon carbide crystals, including:
a crucible, wherein a seed crystal for growing silicon carbide crystals is arranged on a top wall of the crucible; and
an annular guide plate, wherein the annular guide plate is arranged in the crucible, a bottom end of the annular guide plate is connected to a side wall of the crucible, a top end of the annular guide plate extends toward the seed crystal, a gap is formed between the top end and an edge of the seed crystal, a first chamber is defined by the annular guide plate, the seed crystal, the side wall of the crucible and a bottom wall of the crucible jointly, a second chamber is defined by the annular guide plate, the seed crystal, the side wall of the crucible and the top wall of the crucible jointly, the first chamber is communicated with the second chamber through the gap, and a pressure equalizing structure for balancing a pressure of the first chamber and a pressure of the second chamber is arranged on the annular guide plate.

In an implementation according to the invention, the pressure equalizing structure includes air holes formed in the annular guide plate, and the air holes are communicated with the first chamber and the second chamber.

In an implementation according to the invention, the air holes incline toward the seed crystal.

In an implementation according to the invention, hole diameters of the air holes are gradually reduced in a direction close to the seed crystal.

In an optional implementation, there are a plurality of air holes, and the plurality of air holes are formed into a circle or a plurality of circles around an axis of the crucible.

In an optional implementation, the plurality of air holes are formed into the plurality of circles around the axis of the crucible, the plurality of circles of air holes are arranged in a radial direction of the crucible at intervals, and any two adjacent circles of air holes are staggered in the radial direction of the crucible.

In an optional implementation, the pressure equalizing structure includes a first annular portion and a second annular portion, the first annular portion is connected with the second annular portion at an angle, an end, away from the second annular portion, of the first annular portion is connected with an inner wall of the crucible, an end, away from the first annular portion, of the second annular portion extends toward the seed crystal, and the air holes are formed in the first annular portion.

In an optional implementation, the first annular portion is tabulated and perpendicular to the axis of the crucible, an outer peripheral wall of the first annular portion is connected with the side wall of the crucible, the second annular portion is a hollow cylinder or a hollow circular truncated cone, a bottom end of the second annular portion is connected with an inner peripheral wall of the first annular portion, and a top end of the second annular portion extends toward the seed crystal.

The pressure equalizing structure may include silicon carbide powder placed in the second chamber.

In an optional implementation, at least one concentration adjusting through hole is formed in a position, located on an outer periphery of the second chamber, of the crucible.

In an optional implementation, the first annular portion includes a plurality of layers of vertically-distributed sub annular portions, and the air holes are distributed in each of the plurality of layers of sub annular portions.

In an optional implementation, the air holes with the hole diameters gradually reduced are formed in the plurality of layers of sub annular portions in a transport direction of crystal growth components.

In a second aspect, the present disclosure further provides a method for growing high-quality silicon carbide crystals, and based on the apparatus for growing the high-quality silicon carbide crystals provided by any one of the implementations, the method includes:
placing silicon carbide powder in a crucible;
pumping air from the crucible and then filling inert gas into the crucible;
heating the crucible so as to raise a temperature inside the crucible to 2,000-2,600°C;
exhausting the crucible again to reduce a pressure inside the crucible to 0.01-4E3 Pa;
sublimating the silicon carbide powder and starting to grow silicon carbide crystals on a seed crystal;
after the silicon carbide crystals grow for 10-300 h, filling the inert gas into the crucible again to elevate the pressure inside the crucible to 5E3-1E5 Pa; and
at the end of the growth of the silicon carbide crystals, stopping heating the crucible, and taking out the silicon carbide crystals from the crucible after the temperature inside the crucible is reduced to a room temperature.

In a third aspect, the present disclosure further provides silicon carbide crystals, which are prepared through the method for growing the high-quality silicon carbide crystals as described in the implementations.

The embodiments of the present disclosure have the following beneficial effects, for example,
the apparatus for growing the high-quality silicon carbide crystals provided by the present disclosure includes the crucible and the annular guide plate, and the seed crystal for growing the silicon carbide crystals is arranged on the top wall of the crucible. The annular guide plate is arranged in the crucible, a bottom end of the annular guide plate is connected to a side wall of the crucible, a top end of the annular guide plate extends toward the seed crystal, and a gap is formed between the top end and an edge of the seed crystal. A first chamber is defined by the annular guide plate, the seed crystal, the side wall of the crucible and a bottom wall of the crucible jointly, a second chamber is defined by the annular guide plate, the seed crystal, the side wall of the crucible and the top wall of the crucible jointly, and the first chamber is communicated with the second chamber through the gap. A pressure equalizing structure for balancing pressures of the first chamber and the second chamber is arranged on the annular guide plate. By arranging the pressure equalizing structure on the annular guide plate, a pressure difference between the first chamber and the second chamber can be effectively reduced, the pressures of the two chambers are as close as possible, and the flow rate of gaseous-phase crystal growth components at the gap between the top end of the annular guide plate and the edge of the seed crystal can be effectively reduced accordingly, such that the growth rate of the silicon carbide crystals on the edge of the seed crystal and the growth rate of the silicon carbide crystals in a center of the seed crystal are the same as much as possible, and then the defects such as a "concave interface" on the silicon carbide crystals on the seed crystal are avoided, thereby improving the growth quality of the silicon carbide crystals.

From another perspective, the defects such as surrounding polycrystals and phase change caused by too high concentration of the gaseous-phase crystal growth components on the edge of the crystal and too high growth rate or the adverse influence on the growth quality of the crystal caused by the formation of the concave interface of the crystal are avoided by controlling concentration distribution of the gaseous-phase crystal growth components in a radial direction.

Accordingly, the silicon carbide crystals prepared through the method for growing the high-quality silicon carbide crystals have the characteristics of fewer defects and high quality by utilizing the above apparatus.

### BRIEF DESCRIPTION OF THE DRAWINGS

In order to more clearly explain the technical solutions of embodiments of the present disclosure, drawings required to be used in the embodiments will be briefly described below, it should be understood that the following drawings only illustrate some embodiments of the present disclosure, and thus should not be regarded as limitative, and according to which, those ordinarily skilled in the art can also obtain other drawings without involving inventive efforts.
FIG. 1 is a schematic structural diagram of an apparatus for growing high-quality silicon carbide crystals provided by Embodiment 1 of the present disclosure;
FIG. 2 is a schematic structural diagram of an annular guide plate provided by Embodiment 1 of the present application;
FIG. 3 is a schematic structural diagram of an apparatus for growing high-quality silicon carbide crystals provided by Embodiment 2 of the present disclosure;
FIG. 4 is a schematic structural diagram of an apparatus for growing high-quality silicon carbide crystals provided by Embodiment 5 of the present disclosure; and
FIG. 5 is a schematic structural diagram of an apparatus for growing high-quality silicon carbide crystals provided by Embodiment 6 of the present disclosure.

Reference signs: 100-crucible; 102-first chamber; 104-second chamber; 106-gap; 108-concentration adjusting hole; 110-seed crystal; 200-annular guide plate; 210-first annular portion; 212-air hole; 214-sub annular portion; 220-second annular portion; 222-fillet; 300-silicon carbide powder; and 400-silicon carbide crystal.

### DETAILED DESCRIPTION OF THE EMBODIMENTS

In order to make the objectives, technical solutions and advantages of the embodiments of the present disclosure clearer, the technical solutions in the embodiments of the present disclosure will be described clearly and completely with reference to the embodiments of the present disclosure. Apparently, the described embodiments are part of the embodiments, not all of the embodiments. The components of the embodiments of the present disclosure generally described and illustrated in the drawings herein may be arranged and designed in a wide variety of different configurations.

Thus, the following detailed description of the embodiments of the present disclosure, as presented in the drawings, is not intended to be limitative to the present disclosure, as claimed, but is merely representative of selected embodiments of the present disclosure. All other embodiments obtained by those ordinarily skilled in the art based on the embodiments of the present disclosure without involving inventive efforts should fall within the present disclosure.

It should be noted that like reference numerals and letters denote like items in the following drawings, and thus once an item is defined in one drawing, no further definition or explanation thereof is necessary in the following drawings.

In the description of the present disclosure, it should be understood that orientation or position relationships indicated by terms "upper", "lower", "inner", "outer", and the like are orientation or position relationships shown in the drawings, or orientation or position relationships based on which products of the present disclosure are usually placed, are adopted not to indicate or imply that indicated apparatuses or elements must be in specific orientations or structured and operated in specific orientations but only to conveniently describe the present disclosure and simplify the description, and thus should not be understood as a limitation to the present disclosure.

In addition, terms "first", "second", and the like are merely used for distinguishing between descriptions and should not be understood as the indication or implication of relative importance.

It should be noted that the features in the embodiments of the present disclosure may be mutually combined without conflicts.

A guide plate is usually arranged on a side wall of an existing crucible for growing silicon carbide crystals in order to increase the growth rate of the silicon carbide crystals on a seed crystal, which is used for guiding gaseous-phase crystal growth components to directly flow to the seed crystal on a top wall of the crucible. However, in order to prevent the interference between the guide plate and the seed crystal, a position of a top end of the guide plate will be limited, such that a certain gap is formed between the guide plate and an edge of the seed crystal. Such gap will lead to a certain pressure difference between a chamber above the guide plate and a chamber below the guide plate at the early growth stage of the silicon carbide crystals, and the gaseous-phase crystal growth components have a high flow rate at such gap, that is, the flow rate of the gaseous-phase crystal growth components on the edge of the seed crystal is far higher than that in a center of the seed crystal, inevitably resulting in that the growth rate of the silicon carbide crystals on the edge of the seed crystal is far higher than that in the center of the seed crystal, such that the growth quality of the silicon carbide crystals is affected due to defects such as a "concave interface" easily appearing on the silicon carbide crystals.

In view of the above situation, the present disclosure provides an apparatus and method for growing high-quality silicon carbide crystals. By arranging a pressure equalizing structure on an annular guide plate in a crucible, pressures of two chambers above and below the guide plate in the crucible can be effectively balanced, a pressure difference between the two chambers can be effectively reduced, and the flow rate of gaseous-phase crystal growth components at a gap between a top end of the guide plate and an edge of a seed crystal can be effectively reduced accordingly, such that the growth rate of the silicon carbide crystals on the edge of the seed crystal and the growth rate of the silicon carbide crystals in a center of the seed crystal are the same as much as possible, and then the defects such as a "concave interface" on the silicon carbide crystals are avoided, thereby improving the growth quality of the silicon carbide crystals.

The overall structure, working principle and technical effect of the apparatus for growing the high-quality silicon carbide crystals and the detailed steps of the corresponding method provided by the present disclosure are described in detail below by way of embodiments with reference to the drawings.

### Embodiment 1

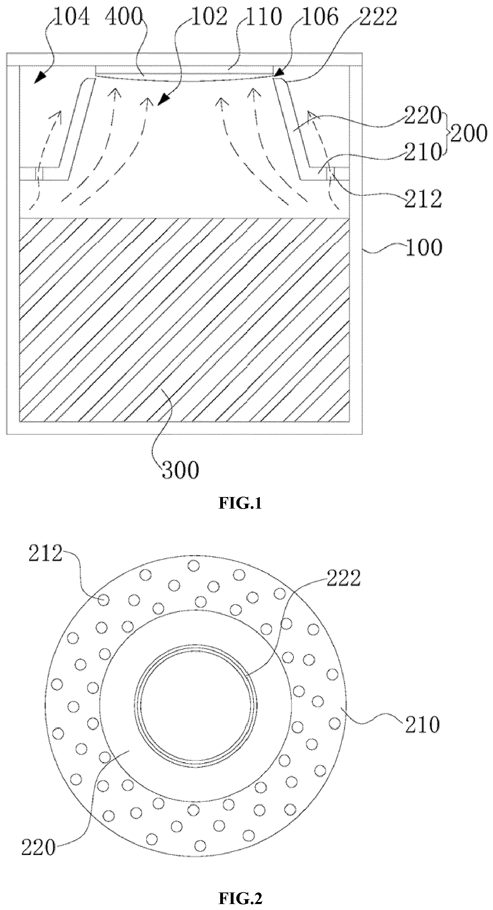

Referring to FIG. 1 and FIG. 2, an apparatus for growing high-quality silicon carbide crystals provided by the present disclosure includes a crucible 100, an annular guide plate 200, a heat insulating structure (not shown) and a heating structure (not shown). Wherein the heating structure and the heat insulating structure are both arranged on an outer side of the crucible 100, and the heating structure is used for generating heat within the crucible 100 so as to sublimate silicon carbide powder 300 at a bottom of the crucible to form gaseous-phase crystal growth components, which specifically may be achieved through induction heating or resistance heating and the like. The heat insulating structure is used for slowing down heat dissipation of the crucible 100, which specifically may be graphite felt or graphite paper and the like.

A seed crystal 110 for growing silicon carbide crystals 400 is arranged on a top wall of the crucible 100 (the crucible 100 usually includes a crucible body and a crucible cover detachably connected with the crucible body, the top wall of the crucible 100 is formed by the crucible cover, and a bottom wall and a side wall the crucible 100 are formed by the crucible body), and methods for fixing the seed crystal 110 include but are not limited to bonding, clamping and the like. The bottom wall and the side wall of the crucible 100 are jointly used for containing the silicon carbide powder 300.

The annular guide plate 200 is arranged in the crucible 100 and used for guiding the gaseous-phase crystal growth components formed after the silicon carbide powder 300 sublimates to flow to the seed crystal 110, so as to achieve the growth of the silicon carbide crystals 400.

In detail, a bottom end of the annular guide plate 200 is connected to the side wall of the crucible 100, and usually connected to a middle-upper portion of the side wall of the crucible 100. A top end of the annular guide plate 200 extends toward the seed crystal 110, and a gap 106 is formed between the top end and an edge of the seed crystal 110.

Internal space of the crucible 100 is divided into two chambers by the annular guide plate 200 and the seed crystal 110, wherein a first chamber 102 is defined by the annular guide plate 200, the seed crystal 110, part of the side wall of the crucible 100 (portion located below the annular guide plate 200) and the bottom wall of the crucible 100 jointly, and a second chamber 104 is defined by the annular guide plate 200, the seed crystal 110, part of the side wall of the crucible 100 (portion located above the annular guide plate 200) and the top wall of the crucible 100 jointly. The first chamber 102 includes a large chamber and a small chamber communicated with the large chamber, the large chamber is cylindrical approximately, the small chamber is a circular truncated cone approximately and located above the large chamber, and the second chamber 104 is annular approximately and surrounds the small chamber. The first chamber 102 is communicated with the second chamber 104 through the gap 106, and the gaseous-phase crystal growth components formed by heating the silicon carbide powder 300 in the crucible 100 for sublimation may flow into the second chamber 104 from the annular gap 106 while flowing to the seed crystal 110 upwards in the first chamber 102.

The annular guide plate 200 may be of different structures as needed. Referring to FIG. 1 again, in this embodiment, the annular guide plate 200 includes a first annular portion 210 and a second annular portion 220, the first annular portion is connected with the second annular portion at an angle, axes of the first annular portion 210 and the second annular portion 220 both coincide with an axis of the crucible 100, an end, away from the second annular portion 220, of the first annular portion 210 is connected with an inner wall of the crucible 100, and an end, away from the first annular portion 210, of the second annular portion 220 extends toward the seed crystal 110.

In this embodiment, the first annular portion 210 is tabulated and perpendicular to the axis of the crucible 100, and an outer peripheral wall of the first annular portion 210 is connected with the side wall of the crucible 100. The second annular portion 220 is a hollow circular truncated cone, a bottom end of the second annular portion 220 is connected with an inner peripheral wall of the first annular portion 210, and a top end of the second annular portion extends toward the seed crystal 110. Due to the arrangement of the hollow circulated truncated cone, on one hand, resistance to the gaseous-phase crystal growth components can be reduced, and on the other hand, the gaseous-phase crystal growth components can also be more effectively guided to flow to the seed crystal 110.

It should be noted that in other embodiments, the first annular portion 210 may also be a hollow circulated truncated cone; the second annular portion 220 may also be a hollow cylinder; the annular guide plate 200 may also include at least three annular portions, the at least three annular portions are in included-angle connection in sequence, the annular portion at a lowest position is connected with the side wall of the crucible 100, and the annular portion at a highest position extends to a position close to the edge of the seed crystal 110.

Furthermore, a pressure equalizing structure for balancing pressures of the first chamber 102 and the second chamber 104 is arranged on the annular guide plate 200. The pressure equalizing structure may be of different structures as needed. Referring to FIG. 1 again, in this embodiment, the pressure equalizing structure includes air holes 212 formed in the annular guide plate 200, the air holes 212 are communicated with the first chamber 102 and the second chamber 104, that is, the first chamber 102 and the second chamber 104 are also communicated through the air holes 212 besides through the gap 106.

Thus, the gaseous-phase crystal growth components in the first chamber 102 may further flow into the second chamber 104 through the air holes 212 while being guided by the annular guide plate 200 to flow to the seed crystal 110 (see FIG. 1 for details, and a dotted line with an arrow in the figure represents a flow path of the gaseous-phase crystal growth components), such that the pressure of the second chamber 104 increases along with the increase in the pressure of the first chamber 102, the pressures of the first chamber 102 and the second chamber 104 can be balanced accordingly, so as to reduce a pressure difference between the both; and therefore, the flow rate of the gaseous-phase crystal growth components at the gap 106 is reduced, and the growth rates of the silicon carbide crystals 400 on the edge and in a center of the seed crystal 110 are the same as much as possible, so as to avoid the defect of a "concave interface" appearing in the growth process of the silicon carbide crystals 400, thereby ensuring the growth quality of the silicon carbide crystals 400.

Specific positions of the air holes 212 in the annular guide plate 200 may be set as needed. In this embodiment, in detail, the air holes 212 are formed in the first annular portion 210. In other embodiments, the air holes 212 may also be formed in the second annular portion 220 or simultaneously formed in the first annular portion 210 and the second annular portion 220.

There are a plurality of air holes 212, and the plurality of air holes 212 are formed into a circle or a plurality of circles around the axis of the crucible 100. In this embodiment, the plurality of air holes 212 are formed into the plurality of circles around the axis of the crucible 100, the plurality of circles of air holes 212 are arranged in a radial direction of the crucible 100 at intervals, and any two adjacent circles of air holes 212 are staggered in the radial direction of the crucible 100. A communication area between the first chamber 102 and the second chamber 104 can be effectively increased by arranging the plurality of circles of air holes 212 around the axis of the crucible 100, such that the pressure difference between the first chamber 102 and the second chamber 104 can be more effectively reduced. The uniformity of a plurality of communication positions of the first chamber 102 and the second chamber 104 can be improved by staggering every two adjacent circles of air holes 212, such that pressures at different positions in the second chamber 104 are uniform as much as possible, which is conducive to a rapid increase in the pressure in the second chamber 104 so that the pressure of the second chamber and the pressure of the first chamber 102 can be balanced.

Furthermore, in this embodiment, there are three circles of air holes 212, the number of the air holes 212 in the three circles is equal, which is 16-20, the plurality of air holes 212 in the outermost circle correspond to the plurality of air holes 212 in the middle circle, the plurality of air holes 212 in the middle circle correspond to the plurality of air holes 212 in the innermost circle one to one, a connecting line of circle centers of three corresponding air holes 212 respectively located in the outermost circle, the middle circle and the innermost circle is an arc, and hole diameters of the three air holes 212 are gradually reduced from outside to inside; and due to such arrangement, the gaseous-phase crystal growth components penetrating through the plurality of air holes 212 from the first chamber 102 to enter the second chamber 104 may have a cyclone effect close to an outer wall of the second annular portion 220, such that the gaseous-phase crystal growth components can more rapidly and uniformly arrive at the gap 106 to balance the pressures of the two chambers, so as to reduce the flow rate of the gaseous-phase crystal growth components at the gap 106.

Shapes and orientations of the air holes 212 may also be set according to actual requirements. In this embodiment, the air holes 212 incline toward the seed crystal 110. Furthermore, hole diameters of the air holes 212 are gradually reduced in a direction close to the seed crystal 110. The air holes 212 incline toward the seed crystal 110, such that the gaseous-phase crystal growth components can more rapidly arrive at the gap 106 after penetrating through the air holes 212, so as to increase the raising speed of the pressure of the second chamber 104. A pressure boosting effect is achieved since the hole diameters of the air holes 212 are gradually reduced, which can further increase the raising speed of the pressure of the second chamber 104. Meanwhile, a fillet 222 is arranged at a position, close to an outer periphery of the second chamber 104, of a top end of the second annular portion 220, such that the gaseous-phase crystal growth components in the second chamber 104 can more smoothly arrive at the gap 106, so as to achieve the balance of the pressures of the first chamber 102 and the second chamber 104.

Since the plurality of circles of air holes 212 formed around the axis of the crucible 100 are formed in the annular guide plate 200, the air holes 212 incline toward the seed crystal 110, and the hole diameters of the air holes are gradually reduced, the gaseous-phase crystal growth components in the first chamber 102 can penetrate through the air holes 212 to enter the second chamber 104 and rapidly arrive at the gap 106 between the edge of the seed crystal 110 and the top end of the annular guide plate 200 while rising, the pressures of the first chamber 102 and the second chamber 104 are rapidly balanced accordingly, the flow rate of the gaseous-phase crystal growth components at the gap 106 is reduced, and the silicon carbide crystals 400 can uniformly grow on the edge and in the center of the seed crystal 110, thereby ensuring the quality of the silicon carbide crystals 400.

### Embodiment 2

The overall construction, operation principle and technical effects of an apparatus for growing the high-quality silicon carbide crystals provided by this embodiment are substantially the same as those of Embodiment 1, except for the specific solution of a pressure equalizing structure.

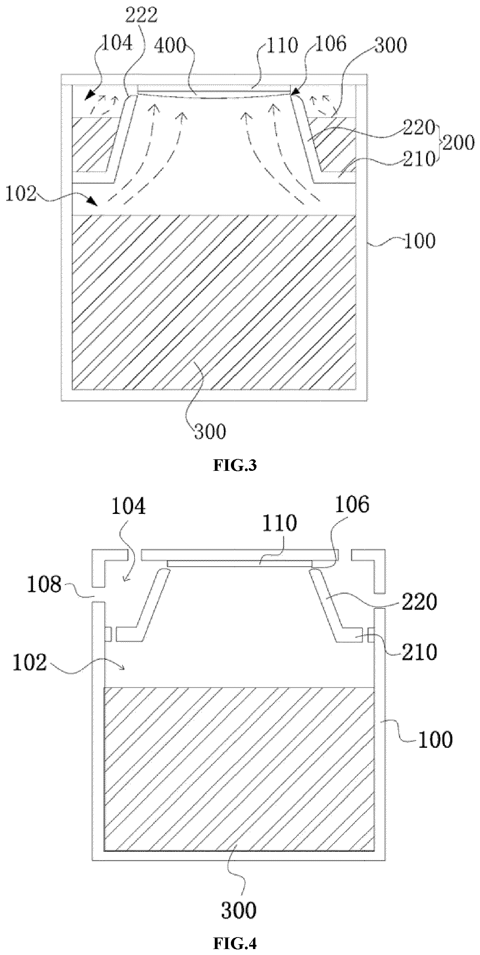

Referring to FIG. 3, in this embodiment, the pressure equalizing structure includes silicon carbide powder 300 placed in a second chamber 104. It is only needed to place a relatively small amount of silicon carbide powder 300 in a second chamber 104 while placing the silicon carbide powder 300 in the first chamber 102 without forming air holes 212 in an annular guide plate 200 in this structural form. Thus, the silicon carbide powder 300 in the second chamber 104 may also be heated for sublimation to form gaseous-phase crystal growth components while gaseous-phase crystal growth components formed after the silicon carbide powder 300 in the first chamber 102 is heated for sublimation flows to the seed crystal 110 upward to grow silicon carbide crystals 400, (see FIG. 2 for details, and a dotted line with an arrow in the figure represents a flow path of the gaseous-phase crystal growth components), such that a pressure of the second chamber 104 increases along with the increase in a pressure of the first chamber 102, the pressures of the first chamber 102 and the second chamber 104 can be reduced as much as possible accordingly, so as to achieve a certain balanced state between the pressures of the both, the flow rate of the gaseous-phase crystal growth components in the first chamber 102 at a gap 106 is reduced, the growth rates of the silicon carbide crystals 400 on an edge and in a center of the seed crystal 110 are the same as much as possible, and the silicon carbide crystals 400 can uniformly grow at all positions of the seed crystal 110, so as to avoid the defects such as a "concave interface", thereby ensuring the growth quality of the silicon carbide crystals 400.

In conclusion, the apparatuses for growing the high-quality silicon carbide crystals provided by Embodiment 1 and Embodiment 2 of the present disclosure both include a crucible 100 and the annular guide plate 200, and a seed crystal 110 for growing the silicon carbide crystals 400 is arranged on a top wall of the crucible 100. The annular guide plate 200 is arranged in the crucible 100, a bottom end of the annular guide plate 200 is connected to a side wall of the crucible 100, a top end of the annular guide plate extends toward the seed crystal 110, and the gap 106 is formed between the top end and the edge of the seed crystal 110. The first chamber 102 is defined by the annular guide plate 200, the seed crystal 110, the side wall of the crucible 100 and a bottom wall of the crucible 100 jointly, the second chamber 104 is defined by the annular guide plate 200, the seed crystal 110, the side wall of the crucible 100 and the top wall of the crucible 100 jointly, and the first chamber 102 is communicated with the second chamber 104 through the gap 106. The pressure equalizing structure for balancing the pressures of the first chamber 102 and the second chamber 104 is arranged on the annular guide plate 200. By arranging the pressure equalizing structure on the annular guide plate 200, a pressure difference between the first chamber 102 and the second chamber 104 can be effectively reduced, the pressures of the two chambers are as close as possible, and the flow rate of the gaseous-phase crystal growth components at the gap 106 between the top end of the annular guide plate 200 and the edge of the seed crystal 110 can be effectively reduced accordingly, such that the growth rate of the silicon carbide crystals 400 on the edge of the seed crystal 110 and the growth rate of the silicon carbide crystals 400 in the center of the seed crystal 110 are the same as much as possible, and then the defects such as the "concave interface" on the silicon carbide crystals 400 on the seed crystal 110 are avoided, thereby improving the growth quality of the silicon carbide crystals 400.

### Embodiment 3

This embodiment provides a method for growing high-quality silicon carbide crystals, which is based on the apparatus provided by Embodiment 1 or Embodiment 2, and specifically includes the following steps:
silicon carbide powder 300 is placed in a crucible 100;
air is pumped from the crucible 100, and then inert gas is filled into the crucible;
the crucible 100 is heated so as to raise a temperature inside the crucible 100 to 2,000-2,600°C;
the crucible 100 is exhausted again to reduce a pressure inside the crucible 100 to 0.01-4E3 Pa;
the silicon carbide powder 300 sublimates, and silicon carbide crystals 400 start to grow on a seed crystal 110;
after the silicon carbide crystals 400 grow for 10-300 h, the inert gas is filled into the crucible 100 again to elevate the pressure inside the crucible 100 to 5E3-1E5 Pa; and
at the end of the growth of the silicon carbide crystals 400, the crucible 100 stops being heated, and the silicon carbide crystals 400 are taken from the crucible 100 after the temperature inside the crucible 100 is reduced to a room temperature.

Wherein the rates of air pumping and air inflation are controlled through the coordination of a mechanical pump, a butterfly valve and a flowmeter. When the silicon carbide powder 300 is placed in the crucible 100, it is only needed to place the silicon carbide powder 300 in a first chamber 102 in a case that it is based on the apparatus provided by Embodiment 1; and it is needed to place the silicon carbide powder 300 in both the first chamber 102 and a second chamber 104 in a case that it is based on the apparatus provided by Embodiment 2.

### Embodiment 4

This embodiment provides silicon carbide crystals 400, which are prepared through the method for growing the high-quality silicon carbide crystals provided by Embodiment 3, and have the characteristics of fewer defects and high quality.

### Embodiment 5

Referring to FIG. 4, compared with Embodiment 1, an apparatus for growing high-quality silicon carbide crystals provided by this embodiment is improved as follows:
A plurality of concentration adjusting through holes 108 are formed in a crucible 100, and the plurality of concentration adjusting through holes 108 are located in a side portion or upper portion of a position where a second chamber 104 is located.

In this embodiment, considering that saturation concentrations of gaseous-phase components, such as Si and Si₂C, are relatively high at the initial stage of crystal growth, gaseous-phase crystal growth components obviously rich in silicon are formed, which is not conducive to the high-quality growth of silicon carbide crystals 400. Redundant silicon-rich components will flow out of the crucible 100 in the presence of the concentration adjusting through holes 108, so as to adjust and control a carbon-silicon ratio of the gaseous-phase crystal growth components in the crucible, which is conducive to improving the growth quality of the silicon carbide crystals 400.

Meanwhile, the concentration adjusting through holes 108 further have a drainage effect, which can guide the gaseous-phase crystal growth components to flow upward, facilitating the generation of the silicon carbide crystals 400.

### Embodiment 6

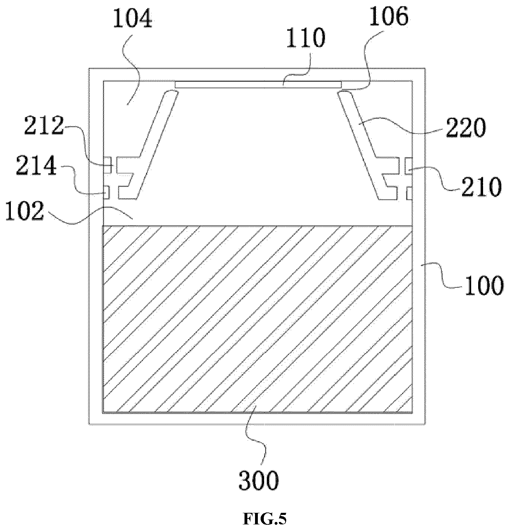

Referring to FIG. 5, compared with Embodiment 1, an apparatus for growing high-quality silicon carbide crystals provided by this embodiment is improved as follows:
A first annular portion 210 includes a sub annular portion 214 on an upper layer and a sub annular portion on a lower layer, air holes 212 are distributed in the two layers of sub annular portions 214, gaseous-phase silicon carbide crystal growth components flow through the two layers of sub annular portions 214 from bottom to top during heating, and the sub annular portion 214 on the lower layer has the air holes 212 with a larger hole diameter compared with the sub annular portion 214 on the upper layer.

Those skilled in the art can easily conceive that the sub annular portions 214 on the upper layer and lower layer in this embodiment may be free of a direct connection relationship, for example, the sub annular portion 214 on the upper layer is connected with a second annular portion 220, and the sub annular portion 214 on the lower layer is connected with a side wall of a crucible 100.

The technical solution of this embodiment aims to balance the distribution of concentrations of the gaseous-phase crystal growth components from the perspective of the flow rate, specifically, the gaseous-phase crystal growth components are more easily heated to a high temperature on an edge of an annular guide plate 200, namely the first annular portion 210, such that the flow rate of the gaseous-phase crystal growth components is high, which is not conducive to the balance of the concentrations of the gaseous-phase crystal growth components; and therefore, the two layers of sub annular portions 214 are arranged, and hole diameters of the air holes 212 are gradually reduced from bottom to top, so as to provide additional resistance to the gaseous-phase crystal growth components flowing rapidly, thereby balancing the distribution of the concentrations of the gaseous-phase crystal growth components in the crucible 100.

Those skilled in the art can easily understand that as a further preference of this embodiment, the sub annular portions 214 may consist of a plurality of layers, such as 3-5 layers.

The hole diameters of the air holes 212 in the sub annular portion 214 on the uppermost layer may be as small as possible or even tend to be zero, so as to provide enough resistance.

The above descriptions are merely the detailed description of embodiments of the present disclosure, which are not intended to be limitative, wherein the protection scope of the present disclosure is defined by the claims.

## Claims

1. An apparatus for growing high-quality silicon carbide crystals,
to sublimate silicon carbide powder, comprising
a crucible (100), wherein a seed crystal (110) for growing silicon carbide crystals (400) is arranged on a top wall of the crucible (100); and
an annular guide plate (200), wherein the annular guide plate (200) is arranged in the crucible (100), wherein a bottom end of the annular guide plate (200) is connected to a side wall of the crucible (100), wherein a top end of the annular guide plate extends toward the seed crystal (110), wherein a gap (106) is formed between the top end and an edge of the seed crystal (110), wherein a first chamber (102) is defined by the annular guide plate (200), the seed crystal (110), the side wall of the crucible (100) and a bottom wall of the crucible (100) jointly, wherein a second chamber (104) is defined by the annular guide plate (200), the seed crystal (110), the side wall of the crucible (100) and the top wall of the crucible (100) jointly, wherein the first chamber (102) is communicated with the second chamber (104) through the gap (106), and wherein a pressure equalizing structure for balancing a pressure of the first chamber (102) and a pressure of the second chamber (104) is arranged on the annular guide plate (200);
wherein the pressure equalizing structure comprises air holes (212) formed in the annular guide plate (200), and wherein the air holes (212) are communicated with the first chamber (102) and the second chamber (104); and wherein the annular guide plate (200) comprises a first annular portion (210), the air holes (212) being formed in the first annular portion (210);
**characterized in**
**that** the annular guide plate (200) comprises a second annular portion (220), the first annular portion being connected with the second annular portion at an angle, an end, away from the second annular portion (220), of the first annular portion (210) being connected with an inner wall of the crucible (100), an end, away from the first annular portion (210), of the second annular portion (220) extending toward the seed crystal (110), and;
**that** the air holes (212) incline toward the seed crystal (110), and hole diameters of the air holes (212) are gradually reduced in a direction close to the seed crystal (110).

2. The apparatus for growing the high-quality silicon carbide crystals according to claim 1, wherein
a plurality of air holes (212) are formed, and the plurality of air holes (212) are formed into a circle or a plurality of circles around an axis of the crucible (100).

3. The apparatus for growing the high-quality silicon carbide crystals according to claim 2, wherein
the plurality of air holes (212) are formed into the plurality of circles around the axis of the crucible (100), the plurality of circles of air holes (212) are arranged in a radial direction of the crucible (100) at intervals, and any two adjacent circles of air holes (212) are staggered in the radial direction of the crucible (100).

4. The apparatus for growing the high-quality silicon carbide crystals according to one of the preceding claims, wherein
the first annular portion (210) is tabulated and perpendicular to an axis of the crucible (100), an outer peripheral wall of the first annular portion (210) is connected with the side wall of the crucible (100), the second annular portion (220) is a hollow cylinder or a hollow circular truncated cone, a bottom end of the second annular portion (220) is connected with an inner peripheral wall of the first annular portion (210), and a top end of the second annular portion extends toward the seed crystal (110).

5. The apparatus for growing the high-quality silicon carbide crystals according to one of the preceding claims, wherein
at least one concentration adjusting through hole (108) is formed in a position, located on an outer periphery of the second chamber (104), of the crucible (100).

6. The apparatus for growing the high-quality silicon carbide crystals according to one of the preceding claims, wherein
the first annular portion (210) comprises a plurality of layers of vertically-distributed sub annular portions (214), and the air holes (212) are distributed in each of the plurality of layers of sub annular portions (214).

7. The apparatus for growing the high-quality silicon carbide crystals according to claim 6, wherein
the air holes (212) with the hole diameters gradually reduced are formed in the plurality of layers of sub annular portions (214) in a transport direction of crystal growth components.

8. A method for growing high-quality silicon carbide crystals, wherein
based on the apparatus for growing the high-quality silicon carbide crystals according to one of claims 1 to 7, the method comprises:
placing silicon carbide powder (300) in a crucible (100);
pumping air from the crucible (100) and then filling inert gas into the crucible;
heating the crucible (100) so as to raise a temperature inside the crucible (100) to 2,000-2,600°C;
exhausting the crucible (100) again so as to reduce a pressure inside the crucible (100) to 0.01-4E3 Pa;
sublimating the silicon carbide powder (300) and starting to grow silicon carbide crystals (400) on a seed crystal (110);
after the silicon carbide crystals (400) grow for 10-300 h, filling the inert gas into the crucible (100) again to elevate the pressure inside the crucible (100) to 5E3-1E5 Pa; and
at the end of the growth of the silicon carbide crystals (400), stopping heating the crucible (100), and taking out the silicon carbide crystals (400) from the crucible (100) after the temperature inside the crucible (100) is reduced to a room temperature.

## Patentansprüche

1. Vorrichtung zum Züchten hochwertiger Siliziumkarbidkristalle,
zum Sublimieren von Siliziumkarbidpulver, umfassend
einen Tiegel (100), wobei ein Keimkristall (110) zum Züchten von Siliziumkarbidkristallen (400) an einer oberen Wand des Tiegels (100) angeordnet ist; und
eine ringförmige Führungsplatte (200), wobei die ringförmige Führungsplatte (200) im Tiegel (100) angeordnet ist, wobei ein unteres Ende der ringförmigen Führungsplatte (200) mit einer Seitenwand des Tiegels (100) verbunden ist, wobei sich ein oberes Ende der ringförmigen Führungsplatte in Richtung des Keimkristalls (110) erstreckt, wobei zwischen dem oberen Ende und einer Kante des Keimkristalls (110) ein Spalt (106) gebildet ist, wobei eine erste Kammer (102) durch die ringförmige Führungsplatte (200), dem Keimkristall (110), der Seitenwand des Tiegels (100) und einer Bodenwand des Tiegels (100) gemeinsam begrenzt ist, wobei eine zweite Kammer (104) durch die ringförmige Führungsplatte (200), den Keimkristall (110), die Seitenwand des Tiegels (100) und die obere Wand des Tiegels (100) gemeinsam begrenzt ist, wobei die erste Kammer (102) über den Spalt (106) mit der zweiten Kammer (104) in Verbindung steht und wobei an der ringförmigen Führungsplatte (200) eine Druckausgleichsstruktur zum Ausgleich des Drucks in der ersten Kammer (102) und des Drucks in der zweiten Kammer (104) angeordnet ist;
wobei die Druckausgleichsstruktur in der ringförmigen Führungsplatte (200) ausgebildete Luftlöcher (212) umfasst und wobei die Luftlöcher (212) mit der ersten Kammer (102) und der zweiten Kammer (104) in Verbindung stehen; und wobei die ringförmige Führungsplatte (200) einen ersten ringförmigen Abschnitt (210) umfasst, wobei die Luftlöcher (212) in dem ersten ringförmigen Abschnitt (210) ausgebildet sind;
**dadurch gekennzeichnet,**
**dass** die ringförmige Führungsplatte (200) einen zweiten ringförmigen Abschnitt (220) umfasst, wobei der erste ringförmige Abschnitt in einem Winkel mit dem zweiten ringförmigen Abschnitt verbunden ist, wobei ein dem zweiten ringförmigen Abschnitt (220) abgewandtes Ende des ersten ringförmigen Abschnitts (210) mit einer Innenwand des Tiegels (100) verbunden ist, wobei sich ein dem ersten ringförmigen Abschnitt (210) abgewandtes Ende des zweiten ringförmigen Abschnitts (220) in Richtung des Keimkristalls (110) erstreckt, und;
**dass** die Luftlöcher (212) zum Keimkristall (110) hin geneigt sind und die Loch-Durchmesser der Luftlöcher (212) in eine Richtung nahe des Keimkristalls (110) allmählich abnehmen.

2. Vorrichtung zum Züchten der hochwertigen Siliziumkarbidkristalle nach Anspruch 1, wobei
eine Vielzahl von Luftlöchern (212) ausgebildet sind, und die Vielzahl von Luftlöchern (212) in Form eines Kreises oder einer Vielzahl von Kreisen um eine Achse des Tiegels (100) angeordnet ist.

3. Vorrichtung zum Züchten der hochwertigen Siliziumkarbidkristalle nach Anspruch 2, wobei
die Vielzahl von Luftlöchern (212) in mehreren Kreisen um die Achse des Tiegels (100) angeordnet sind, die mehreren Kreise aus Luftlöchern (212) in einer radialen Richtung des Tiegels (100) in Abständen angeordnet sind, und jeweils zwei benachbarte Kreise aus Luftlöchern (212) in der radialen Richtung des Tiegels (100) versetzt zueinander angeordnet sind.

4. Vorrichtung zum Züchten der hochwertigen Siliziumkarbidkristalle nach einem der vorstehenden Ansprüche, wobei
der erste ringförmige Abschnitt (210) flach ist und senkrecht zu einer Achse des Tiegels (100) steht, eine Außenumfangswand des ersten ringförmigen Abschnitts (210) mit der Seitenwand des Tiegels (100) verbunden ist, der zweite ringförmige Abschnitt (220) ein Hohlzylinder oder ein hohler, kreisförmiger Kegelstumpf ist, ein unteres Ende des zweiten ringförmigen Abschnitts (220) mit einer inneren Umfangswand des ersten ringförmigen Abschnitts (210) verbunden ist und sich ein oberes Ende des zweiten ringförmigen Abschnitts in Richtung des Keimkristalls (110) erstreckt.

5. Vorrichtung zum Züchten der hochwertigen Siliziumkarbidkristalle nach einem der vorstehenden Ansprüche, wobei
mindestens ein Konzentrationsanpassungs-Durchgangsloch (108) an einer Position am Außenumfang der zweiten Kammer (104) des Tiegels (100) ausgebildet ist.

6. Vorrichtung zum Züchten der hochwertigen Siliziumkarbidkristalle nach einem der vorstehenden Ansprüche, wobei
der erste ringförmige Abschnitt (210) mehrere Schichten vertikal verteilter Unterringabschnitte (214) umfasst, und die Luftlöcher (212) in jeder der mehreren Schichten von Unterringabschnitten (214) verteilt sind.

7. Vorrichtung zum Züchten der hochwertigen Siliziumkarbidkristalle nach Anspruch 6, wobei
die Luftlöcher (212) mit allmählich abnehmenden Loch-Durchmessern in den mehreren Schichten aus Unterringabschnitten (214) in einer Transportrichtung von Kristallwachstumskomponenten ausgebildet sind.

8. Verfahren zum Züchten hochwertiger Siliziumkarbidkristalle, wobei auf der Grundlage der Vorrichtung zum Züchten der hochwertigen Siliziumkarbidkristalle nach einem der Ansprüche 1 bis 7 das Verfahren umfasst:
Einbringen von Siliziumkarbidpulver (300) in einen Tiegel (100);
Absaugen von Luft aus dem Tiegel (100) und anschließendes Einleiten von Inertgas in den Tiegel;
Erhitzen des Tiegels (100), um die Temperatur im Inneren des Tiegels (100) auf 2.000 bis 2.600 °C anzuheben;
erneutes Evakuieren des Tiegels (100), um den Druck im Inneren des Tiegels (100) auf 0,01 bis 4E3 Pa zu senken;
Sublimieren des Siliziumkarbidpulvers (300) und Starten des Wachstums von Siliziumkarbidkristallen (400) auf einem Keimkristall (110);
nachdem die Siliziumkarbidkristalle (400) 10 bis 300 h lang gewachsen sind, erneutes Einleiten des Inertgases in den Tiegel (100), um den Druck im Inneren des Tiegels (100) auf 5E3 bis 1E5 Pa zu erhöhen; und
am Ende des Wachstums der Siliziumkarbidkristalle (400), Beenden des Erhitzens des Tiegels (100), und Entnehmen der Siliziumkarbidkristalle (400) aus dem Tiegel (100), nachdem die Temperatur im Inneren des Tiegels (100) auf Raumtemperatur gesunken ist.

## Revendications

1. Dispositif destiné à la croissance de cristaux de carbure de silicium de haute qualité,
destiné à la sublimation de poudre de carbure de silicium, comprenant
un creuset (100), dans lequel un cristal germe (110) destiné à la croissance de cristaux de carbure de silicium (400) est disposé sur une paroi supérieure du creuset (100) ; et
une plaque de guidage annulaire (200), ladite plaque de guidage annulaire (200) étant disposée dans le creuset (100), une extrémité inférieure de la plaque de guidage annulaire (200) étant reliée à une paroi latérale du creuset (100), l'extrémité supérieure de la plaque de guidage annulaire s'étendant vers le cristal germe (110), un espace (106) étant formé entre l'extrémité supérieure et un bord du cristal germe (110), une première chambre (102) étant délimitée conjointement par la plaque de guidage annulaire (200), le cristal germe (110), la paroi latérale du creuset (100) et une paroi inférieure du creuset (100), dans lequel une deuxième chambre (104) est délimitée conjointement par la plaque de guidage annulaire (200), le cristal germe (110), la paroi latérale du creuset (100) et la paroi supérieure du creuset (100) ; la première chambre (102) communiquant avec la deuxième chambre (104) par l'intermédiaire de l'espace (106), et une structure d'équilibrage de pression destinée à équilibrer la pression de la première chambre (102) et celle de la deuxième chambre (104) étant disposée sur la plaque de guidage annulaire (200) ;
dans lequel la structure d'équilibrage de pression comprend des orifices d'aération (212) formés dans la plaque de guidage annulaire (200), et dans lequel les orifices d'aération (212) communiquent avec la première chambre (102) et la deuxième chambre (104) ; et dans lequel la plaque de guidage annulaire (200) comprend une première partie annulaire (210), les orifices d'aération (212) étant formés dans la première partie annulaire (210) ;
**caractérisé en ce**
**que** la plaque de guidage annulaire (200) comprend une deuxième partie annulaire (220), la première partie annulaire étant reliée à la deuxième partie annulaire selon un angle, une extrémité de la première partie annulaire (210), éloignée de la deuxième partie annulaire (220), étant reliée à une paroi intérieure du creuset (100), une extrémité de la deuxième partie annulaire (220), éloignée de la première partie annulaire (210), s'étendant vers le cristal d'amorçage (110), et ;
**que** les orifices d'aération (212) sont inclinés vers le cristal germe (110), et les diamètres des orifices d'aération (212) sont progressivement réduits dans une direction proche du cristal germe (110).

2. Dispositif destiné à la croissance des cristaux de carbure de silicium de haute qualité selon la revendication 1, dans lequel
une pluralité d'orifices d'aération (212) est formée, et ladite pluralité d'orifices d'aération (212) est disposée en formant un cercle ou une pluralité de cercles autour d'un axe du creuset (100).

3. Dispositif destiné à la croissance des cristaux de carbure de silicium de haute qualité selon la revendication 2, dans lequel
la pluralité d'orifices d'aération (212) est disposée en une pluralité de cercles autour de l'axe du creuset (100), la pluralité de cercles d'orifices d'aération (212) étant agencée à intervalles réguliers dans la direction radiale du creuset (100), et deux cercles adjacents quelconques d'orifices d'aération (212) étant décalés dans la direction radiale du creuset (100).

4. Dispositif destiné à la croissance des cristaux de carbure de silicium de haute qualité selon l'une des revendications précédentes, dans lequel la première partie annulaire (210) est plate et perpendiculaire à l'axe du creuset (100), une paroi périphérique extérieure de la première partie annulaire (210) est reliée à la paroi latérale du creuset (100), la deuxième partie annulaire (220) est un cylindre creux ou un cône tronqué circulaire creux, une extrémité inférieure de la deuxième partie annulaire (220) est reliée à une paroi périphérique intérieure de la première partie annulaire (210), et une extrémité supérieure de la deuxième partie annulaire s'étend vers le cristal germe (110).

5. Dispositif destiné à la croissance des cristaux de carbure de silicium de haute qualité selon l'une des revendications précédentes, dans lequel au moins un trou traversant d'ajustement de concentration (108) est formé à un emplacement situé sur la périphérie extérieure de la deuxième chambre (104) du creuset (100).

6. Dispositif destiné à la croissance des cristaux de carbure de silicium de haute qualité selon l'une des revendications précédentes, dans lequel la première partie annulaire (210) comprend une pluralité de couches de sous-parties annulaires (214) réparties verticalement, et les trous d'aération (212) sont répartis dans chacune des couches de la pluralité de sous-parties annulaires (214).

7. Dispositif destiné à la croissance des cristaux de carbure de silicium de haute qualité selon la revendication 6, dans lequel
les trous d'aération (212), dont les diamètres sont réduits progressivement, sont formés dans la pluralité de couches de sous-parties annulaires (214) dans une direction de transport de composants de croissance cristalline.

8. Procédé de croissance de cristaux de carbure de silicium de haute qualité, dans lequel
sur la base du dispositif destiné à la croissance de cristaux de carbure de silicium de haute qualité selon l'une des revendications 1 à 7, le procédé comprend :
placer de la poudre de carbure de silicium (300) dans un creuset (100) ;
pomper l'air hors du creuset (100), puis remplir celui-ci de gaz inerte ;
chauffer le creuset (100) de manière à porter la température à l'intérieur de celui-ci à une valeur comprise entre 2 000 et 2 600 °C;
mettre à nouveau le creuset (100) sous vide de manière à réduire la pression à l'intérieur du creuset (100) à une valeur comprise entre 0,01 et 4E3 Pa ;
faire sublimer la poudre de carbure de silicium (300) et de commencer à faire croître des cristaux de carbure de silicium (400) sur un cristal germe (110) ;
une fois que les cristaux de carbure de silicium (400) ont cristallisé pendant 10 à 300 h, introduire à nouveau du gaz inerte dans le creuset (100) afin d'élever la pression à l'intérieur du creuset (100) à une valeur comprise entre 5E3 et 1E5 Pa ; et
à la fin de la croissance des cristaux de carbure de silicium (400), arrêter le chauffage du creuset (100), puis retirer les cristaux de carbure de silicium (400) du creuset (100) une fois que la température à l'intérieur du creuset (100) est revenue à température ambiante.
